# EUROPÄISCHE PATENTANMELDUNG

(11) **EP 2 648 233 A1**
(43) Veröffentlichungstag der Anmeldung: **09.10.2013**
(21) Anmeldenummer: 12163169.1
(22) Anmeldetag: 04.04.2012
(51) Int. Cl.: H01L 31/052

(54) **Kühlelement zur Anordnung an zumindest einer Solarzelle, Anordnung aus mehreren Kühlelementen sowie Solarmodulelement**

(71) Anmelder: Milboro Aktiengesellschaft, 9491 Ruggell (LI)
(72) Erfinder: Lechthaler, Andreas, 6710 Nenzing (AT)
(74) Vertreter: Patentbüro Paul Rosenich AG

(57) **Zusammenfassung**

Die Erfindung betrifft ein Kühlelement (21) zur Anordnung an einer Solarzelle (16) mit einem Grundkörper (22), der eine mit der Rückseite (17) der zumindest einen Solarzelle (16) in Anlage bringbare Anlagefläche (23) aufweist. Weiter weist der Grundkörper (22) einen Zulauf für ein Kühlmittel zur Kühlung der Solarzelle (16) und einen Ablauf für das Kühlmittel sowie Seitenwände (24, 25) auf. Die Anlagefläche (23) weist einen zur Anlagefläche (23) offenen Aufnahmeraum (26) mit mehreren, nebeneinander angeordneten Kühlkammern (27) auf. Jede der Kühlkammern (27) weist eine mit dem Zulauf verbundene Zulauföffnung (30) und eine mit dem Ablauf verbundene Ablauföffnung (34) auf.

## Beschreibung

Die Erfindung bezieht sich auf ein Kühlelement zur Anordnung an zumindest einer Solarzelle, der in dem Oberbegriff des Anspruchs 1 genannten Art. Weiter bezieht sich die Erfindung auf eine Anordnung aus mehreren Kühlelementen nach Anspruch 14 und einem Solarmodulelement nach Anspruch 15.

Solarmodulelemente zur Strom- und/oder Warmwassererzeugung umfassen Solarzellen und gewinnen zur Erhaltung der Versorgungssicherheit immer mehr an Bedeutung. Mehrere zumeist gerahmte Solarmodulelemente werden zu Solaranlagen zusammengefasst, welche auf Oberflächen angeordnet werden. In diesem Zusammenhang werden unter dem Begriff "Oberfläche" bei Freilandanlagen der Untergrund und bei Gebäuden z. B. Dachflächen oder Wandflächen verstanden.

In diesem Zusammenhang wird unter dem Begriff "Solarzelle" das stromproduzierende Element und unter dem Begriff "Solarmodul" eine Anordnung aus mehreren, üblicherweise in Reihe geschalteten Solarzellen verstanden. Unter dem Begriff "Solarmodulelement" wird ein Bauelement verstanden, welches ein Solarmodul umfasst. Solche Solarmodulelemente können reine stromproduzierende Elemente (Photovoltaikelemente) oder Hybridelemente sein, mit welchen neben Strom auch noch Wärme erzeugt wird.

Die bei den Solarmodulelementen angegebenen Spitzennennleistungen werden nach den üblichen Normen unter Laborbedingungen bei einer Solarzellentemperatur von üblicherweise 25° C bestimmt. Durch die Bestrahlung mit Sonnenlicht können die Solarzellen der Solarmodulelemente im Sommer jedoch Oberflächentemperaturen von bis zu 80° C erreichen. Es ist aus Versuchen und der Praxis bekannt, dass die Leistung der Stromproduktion der Solarzellen mit steigender Oberflächentemperatur zurückgeht. Zudem sinkt bei hohen Oberflächentemperaturen der Solarzellen die Lebensdauer der einzelnen Solarzelle und somit des Solarmodulelementes massgeblich.

Es gab daher bereits früh verschiedene Ansätze, um durch Kühlung der Solarzellen den Jahresstromertrag derselben zu erhöhen sowie die Lebensdauer von Solarzellen und somit von Solarmodulelementen zu verlängern.

In der DE 10 2007 059 202 A1 wird zur Kühlung eines Solarmodulelementes vorgeschlagen, eine Sprinkleranordnung vorzusehen, die über ein Leitungssystem mit einem Wassertank verbunden ist. Über die Sprinkleranordnung wird entweder Regenwasser oder externes zugeführtes Wasser über den Solarzellen versprüht.

Nachteilig an dieser bekannten Lösung ist, dass zur Kühlung die gesamte Modulfläche mit der Sprinkleranordnung besprenkelt werden muss. Dies bedingt einen komplexen und aufwändigen Aufbau der Kühleinrichtung. An den abfallenden Seiten der Solaranlage muss zudem unterhalb derselben eine Wasserauffangrinne angeordnet sein, welche das Sprinklerwasser sowie gegebenenfalls anfallendes Regenwasser auffängt und in den Wassertank leitet. Um die Gebrauchstauglichkeit dieser Kühleinrichtung zu gewährleisten, ist weiter eine Filtereinrichtung erforderlich.

Aus der EP 0 384 056 A1 ist ein Hybridmodulelement bekannt, bei dem die Solarzellen an deren Rückseite mittels vorbeifliessendem Kühlmittel gekühlt werden. Das Kühlmittel wird entlang zweier zueinander beabstandeten, parallel zu der Rückseite der Solarzellen verlaufenden Ebenen gegenläufig geführt.

Nachteilig an dieser bekannten Lösung ist, dass über die Länge des Solarmodulelementes in Strömungsrichtung des Kühlmittels die Effektivität der Kühlung fortlaufend abnimmt, da sich das Kühlmittel beim Kühlen immerfort erwärmt. Das führt dazu, dass die in Strömungsrichtung des Kühlmittels unteren bzw. nachfolgenden Solarzellen nicht mehr oder nur noch zu einem geringen, unzureichenden Grad gekühlt werden.

Aus der WO 2008/094555 A2 ist ein Kühlelement zur Anordnung an zumindest einer Solarzelle mit einem wannenförmigen Grundkörper bekannt, der eine mit der Rückseite der zumindest einen Solarzelle in Anlage bringbare Anlagefläche, einen Zulauf für ein Kühlmittel und einen Ablauf für das Kühlmittel sowie Seitenwände aufweist. Der Anlagefläche ist ein mit mehreren längs und quer sowie zueinander beabstandet angeordneten Vorsprüngen versehener Aufnahmeraum für das Kühlmittel zur Kühlung der zumindest einen Solarzelle zugewandt. Durch die Vorsprünge im Aufnahmeraum, welche sich im montierten Zustand des Kühlelementes an der Rückseite der Solarzelle nicht bis zur Rückseite der Solarzelle erstrecken, wird das Strömungsverhalten des Kühlmittels beeinflusst. Damit soll die Kühlung der Solarmodule beziehungsweise der in Strömungsrichtung des Kühlmittels unteren Solarzellen verbessert werden.

Nachteilig an dieser bekannten Lösung ist, dass weiterhin über die Länge des Solarmodulelementes in Strömungsrichtung des Kühlmittels die Effektivität der Kühlung fortlaufend abnimmt und somit eine optimale Kühlung aller Solarzellen nicht überall des Solarmoduls gewährleistet ist.

Aufgabe der vorliegenden Erfindung ist es somit, ein Kühlelement zur Anordnung an zumindest einer Solarzelle zu schaffen, welches die vorgenannten Nachteile nicht aufweist und welches insbesondere eine optimale Kühlung der Solarzelle einfach und flexibel gewährleistet. Weiter ist es Aufgabe der vorliegenden Erfindung, eine Anordnung zur Kühlung mehrerer Solarzellen sowie ein Solarmodul zu schaffen, bei dem die Solarzellen optimal gekühlt werden.

Die erste Aufgabe wird durch die Merkmale des unabhängigen Anspruchs 1 gelöst. Vorteilhafte Weiterbildungen sind in den Figuren und in den abhängigen Patentansprüchen dargelegt.

Gemäss der Erfindung weist der Aufnahmeraum mehrere, nebeneinander angeordnete Kühlkammern auf, wobei jede der Kühlkammern eine mit dem Zulauf verbundene Zulauföffnung und eine mit dem Ablauf verbundene Ablauföffnung aufweist.

Da die Kühlebene von der Ablaufebene, in welcher das in den Kühlkammern erwärmte Kühlmittel ab- beziehungsweise zurückfliesst, beabstandet ist, wird eine Durchmischung des von erwärmten Kühlmittel mit neu zugeführtem Kühlmittel verhindert, was zu einer vorteilhaften Kühlung der Solarzelle führt.

Neben dem Kühlen der Solarzellen ist es auch denkbar, z. B. in Regionen mit tiefen Aussentemperaturen, die Solarzellen mit dem Kühlmittel auf ein vordefiniertes Temperaturniveau zu erwärmen. Damit wird auch in Regionen mit tiefen Aussentemperaturen sichergestellt, dass die Solarzellentemperatur in einem optimalen Bereich liegt, beispielsweise etwa 25° C beträgt. Zudem können mit einem erwärmten Kühlmittel Schneeablagerungen und Eisbildung auf den Solarzellen verhindert beziehungsweise solche von den Solarzellen einfach entfernt werden. Um eine einfache Lesbarkeit der vorliegenden Anmeldung zu gewährleisten, wird nachfolgend in der Beschreibung jeweils nur die Kühlung beschrieben, d. h. das Absenken der Oberflächentemperatur der Solarzellen. Der Vorgang des "Erwärmens" der Solarzelle entspricht bei dem erfindungsgemässen Kühlelement jedoch dem Vorgang des "Kühlens", wobei das Kühlmittel selbstverständlich ein entsprechendes, d. h. höheres Temperaturniveau als die Aussentemperatur aufweist.

Bei einer grossen Anzahl von einzelnen Kühlkammern ist eine gleichmässige und zumeist effektivere Kühlung der entsprechenden Solarzelle gegeben. Die Kühlkammern sind vorteilhaft jeweils umfänglich geschlossen und erstrecken sich weiter vorteilhaft im Wesentlichen bis zu der von der Anlagefläche des Kühlelementes aufgespannten Ebene. Vorteilhaft sind 50 bis 600 Kühlkammern pro Solarzelle und besonders vorteilhaft 100 bis 250 Kühlkammern pro Solarzelle vorgesehen, so dass eine optimale Kühlung der Solarzelle gegeben ist.

Das durch den Zulauf dem Kühlelement zugeführte Kühlmittel, z. B. Wasser oder eine aufbereitete Mischung, strömt in jede Kühlkammer im Wesentlichen mit derselben Ausgangstemperatur ein, so dass jeder Bereich der Solarzelle unabhängig von seiner Lage in Bezug auf den Zulauf des Kühlmittels in vorteilhafter Weise und im Wesentlichen gleichmässig gekühlt wird. Das Kühlelement wird beispielsweise an der Rückseite der Solarzelle festgelegt, beispielsweise an dieser mit einem vorteilhaft wärmebeständigen und witterungsbeständigen Kleber angeklebt. Besonders geeignet haben sich Kleber erwiesen, wie sie im Automobilbereich zur Festlegung von Autoscheiben zur Anwendung kommen.

Wird für jede einzelne Solarzelle ein separates Kühlelement vorgesehen, weist dieses Abmessungen auf, die im angeordneten Zustand einen Überstand auf vorteilhaft allen Seiten der entsprechenden Solarzelle aufweisen. Üblicherweise sind nebeneinander, in einer gemeinsamen Ebene angeordnete Solarzellen jeweils beabstandet zueinander angeordnet, um einen Kurzschluss zwischen den Solarzellen zu verhindern. Beispielsweise bei quadratischen Solarzellen mit einer üblichen Kantenlänge von 156 mm weist das vorteilhaft ebenfalls quadratische Kühlelement eine Kantenlänge von beispielsweise 158 mm auf.

Alternativ weist das Kühlelement Abmessungen auf, welche die Anordnung von mehr als einer Solarzelle auf diesem Kühlelement ermöglichen. Vorteilhaft entsprechen die Kantenlängen des Kühlelementes dem Vielfachen der Summe aus der entsprechenden Kantenlänge der Solarzelle und eventuell des Abstandes zwischen denselben. Dabei kann das Kühlelement im Grundriss die gleichen Kantenlängen, z. B. quadratisch ausgebildet sein, oder auch unterschiedliche Kantenlängen aufweisen, z. B. rechteckig ausgebildet sein.

Die Temperaturdifferenz des aus dem Kühlelement austretenden Kühlmittels kann genutzt werden, beispielsweise zur Energiegewinnung über einen Wärmetauscher.

Neben Kühlmitteln, auch Kühlmedium genannt, in flüssiger Form, wie beispielsweise denaturiertes Wasser, können auch gasförmige Kühlmittel zur Anwendung gelangen. In diesem Zusammenhang wird in dieser Anmeldung unter "fliessen" auch "strömen" verstanden.

Vorzugsweise ist die Ablauföffnung beabstandet zu der Zulauföffnung angeordnet, so dass die entsprechende Kühlkammer vom Kühlmittel durchflossen und dadurch die entsprechende Solarzelle optimal gekühlt wird. Die Kühlkammern eines Kühlelementes sind vorteilhaft im Wesentlichen alle gleich ausgebildet. Dadurch wird sichergestellt, dass das Delta des Drucks und das Delta der Temperatur nahezu gleich gross sind.

Vorteilhaft sind die Zulauföffnung an einem ersten Endbereich der entsprechenden Kühlkammer und die Ablauföffnung an einem zweiten, dem ersten Endbereich abgewandten Endbereich angeordnet. Damit wird eine vollständige Durchströmung und somit eine optimale Kühlung des entsprechenden Zellbereichs der Solarzelle gewährleistet.

Besonders vorteilhaft ist bei einer geneigten Anordnung des Kühlelementes die Zulauföffnung in Bezug auf die Falllinie des Kühlelementes unterhalb der Ablauföffnung angeordnet, so dass ein vorteilhaftes Durchströmen der Kühlkammer mit einer hohen Kühlungseffizienz des entsprechenden Zellbereichs der Solarzelle gewährleistet ist. Das Kühlmittel dringt durch die Zulauföffnung in die Kühlkammer ein und steigt entgegen der Schwerkraft in Richtung der Falllinie des Kühlelementes infolge des von dem nachströmenden Kühlmittels erzeugten Druck an, bis das Kühlmittel durch die Ablauföffnung wieder aus der entsprechenden Kühlkammer austritt. Dadurch wird eine vorteilhaft definierte Verweildauer des Kühlmittels in der Kühlkammer zur Kühlung des entsprechenden Bereichs der Solarzelle sichergestellt. Dabei wird gleichzeitig ein zu massives Erwärmen des Kühlmittels, welches für die Kühlung der Solarzelle nachteilig wäre, in der Kühlkammer verhindert.

Bevorzugt erfolgt der Zulauf des Kühlmittels in einer parallel zur Anlagefläche angeordneten Zulaufebene, was eine einfache Ausgestaltung des Kühlelementes und der Verbindung vom Zulauf zu der Zulauföffnung jeder der Kühlkammern ermöglicht.

Vorzugsweise erfolgt der Ablauf des Kühlmittels in einer parallel zur Anlagefläche angeordneten Ablaufebene, was eine einfache Ausgestaltung des Kühlelementes und der Verbindung vom Ablauf von der Ablauföffnung jeder der Kühlkammern ermöglicht.

Bevorzugt ist die Ablaufebene zwischen der Anlagefläche und der Zulaufebene angeordnet, womit eine einfache Ausgestaltung des Kühlelementes und ein vorteilhafter Strömungsverlauf des Kühlmittels in dem Kühlelement gewährleistet werden.

Vorzugsweise sind zumindest zwei, voneinander beabstandete Zulaufkanäle mit einer Längserstreckung in der Zulaufebene vorgesehen, was die Zuführung des Kühlmittels in die Kühlkammern bei einem vorteilhaften Strömungsverhalten des Kühlmittels im Kühlelement sicherstellt. Ergänzend oder alternativ dazu sind zumindest zwei, voneinander beabstandete Ablaufkanäle mit einer Längserstreckung in der Ablaufebene vorgesehen, was die Ableitung des Kühlmittels aus den Kühlkammern bei einem vorteilhaften Strömungsverhalten des Kühlmittels im Kühlelement sicherstellt.

Bevorzugt verläuft die Längserstreckung der Ablaufkanäle quer zur Längserstreckung der Zulaufkanäle, womit zusätzlich ein vorteilhaftes Strömungsverhalten des Kühlmittels im Kühlelement sichergestellt ist. Diese Ausgestaltung des Kühlelementes ist insbesondere bei einer geneigten Anordnung des Kühlelementes vorteilhaft.

Vorzugsweise ist der Querschnitt quer zur Längserstreckung eines Zulaufkanals grösser als der Querschnitt quer zur Längserstreckung eines Ablaufkanals ausgebildet, womit zusätzlich ein vorteilhaftes Strömungsverhalten des Kühlmittels aufgrund der resultierenden unterschiedlichen Druckverhältnisse und Strömungsverhältnisse im Kühlelement sichergestellt ist. Des Weiteren ergibt sich durch diese Ausgestaltung der Zulaufkanäle in Bezug auf die Ablaufkanäle ein hydraulischer Widerstand, welcher einen unerwünschten Rücklauf des Kühlmittels zurück in einen Zulaufkanal verhindert.

Bevorzugt ist die Zulaufebene zu zumindest einer der Seitenwände, vorteilhaft zu beiden, einander gegenüberliegenden Seitenwänden offen, was eine einfache Zuführung des Kühlmittels in das Kühlelement ermöglicht. Umfasst die Zulaufebene Zulaufkanäle, dann sind vorteilhaft alle diese Zulaufkanäle zu zumindest einer der Seitenwände, vorteilhaft zu beiden, einander gegenüberliegenden Seitenwänden offen. Ergänzend oder alternativ dazu ist die Ablaufebene zu zumindest einer der Seitenwände, vorteilhaft zu beiden, einander gegenüberliegenden Seitenwänden offen, was eine einfache Ableitung des Kühlmittels aus dem Kühlelement ermöglicht. Umfasst die Ablaufebene Ablaufkanäle, dann sind vorteilhaft alle diese Ablaufkanäle zu zumindest einer der Seitenwände, vorteilhaft zu beiden, einander gegenüberliegenden Seitenwänden offen.

Vorzugsweise ist an einander gegenüberliegenden Seitenwänden des Grundkörpers jeweils ein Teil einer Verbindungsvorrichtung vorgesehen, wobei vorteilhaft der eine Teil der Verbindungsvorrichtung an einer Seitenwand komplementär zu einem anderen Teil der Verbindungsvorrichtung an der gegenüberliegenden Seitenwand ausgebildet ist. Mit dieser Ausgestaltung des Kühlelementes lassen sich mehrere, in einer Ebene angeordnete Kühlelemente miteinander verbinden und so einfach eine Anordnung zur Kühlung mehrerer, in einer Ebene angeordneter Solarzellen bilden. Die Verbindungseinrichtung ist vorteilhaft derart ausgebildet, dass mehrere Kühlelemente werkzeuglos miteinander verbindbar sind.

Besonders vorteilhaft ist an allen Seitenwänden des Grundkörpers jeweils ein Teil einer Verbindungsvorrichtung vorgesehen, wobei auch in einer solchen Ausführungsform die Teile der Verbindungseinrichtung an einander gegenüberliegenden Seitenwänden komplementär ausgebildet sind. Dies ermöglicht, an allen Seitenwänden eines Kühlelementes ein weiteres, vorteilhaft gleichartig ausgebildetes Kühlelement anzuordnen. Dadurch kann z. B. eine grossflächige Anordnung aus mehreren Kühlelementen zur Kühlung mehrerer, in einer Ebene angeordneter Solarzellen ausgebildet werden.

Vorteilhaft umfasst die Verbindungseinrichtung eine Steckverbindung, welche eine einfache Verbindung mehrerer Kühlelemente miteinander ermöglicht. Ergänzend oder alternativ dazu umfasst die Verbindungseinrichtung eine Nut-/Kammverbindung, welche ebenfalls eine einfache Verbindung mehrerer Kühlelemente miteinander ermöglicht.

Bevorzugt ist an einer der Seitenwände ein Vertiefungskanalabschnitt vorgesehen, so dass beim Zusammenführen von zwei Kühlelementen an dieser Seitenwand ein Kanal für das Kühlmittel zwischen den Kühlelementen ausgebildet ist. Vorteilhaft weisen beide zusammenzuführende Kühlelemente an den Seitenwänden, welche im zusammengeführten Zustand einander benachbart sind, jeweils einen Vertiefungskanalabschnitt auf. In einer solchen Ausführungsform sind die Vertiefungskanalabschnitte vorteilhaft jeweils auf der gleichen Höhe in Bezug auf die Anlagefläche der Kühlelemente angeordnet, so dass ein im Wesentlichen umfänglich geschlossenen Kanal für das Kühlmittel durch die Vertiefungskanalabschnitte zwischen den nebeneinander angeordneten Kühlelementen ausgebildet ist.

Vorteilhaft ist der Vertiefungskanalabschnitt an der Seitenwand mit der offenen Ablaufebene beziehungsweise mit den offenen Ablaufkanälen vorgesehen, so dass der beim Zusammenführen von zwei Kühlelementen an dieser Seitenwand ausgebildete Kanal der Ableitung des Kühlmittels dienen kann. Weiter vorteilhaft ist der Vertiefungskanalabschnitt beabstandet zu der offenen Ablaufebene beziehungsweise zu den Öffnungen des Ablaufkanals angeordnet, was eine vorteilhafte Ableitung des in den Kühlkammern erwärmten Kühlmittels ermöglicht. Des Weiteren ergibt sich eine vorteilhafte Ausgestaltung des Kühlelementes, wenn die Längserstreckung des Vertiefungskanalabschnitts quer zur Längserstreckung der Ablaufkanäle in der Ablaufebene verläuft.

Vorteilhaft ragen von zumindest einer der Seitenwände Distanznoppen ab, welche beim Zusammenführen von zwei Kühlelementen Kanalabschnitte für das Kühlmittel ausbilden. Diese Distanznoppen sind vorteilhaft an der Seitenwand mit der offenen Ablaufebene beziehungsweise mit den offenen Ablaufkanälen angeordnet, so dass in diesem Bereich Ableitungsabschnitte für das Kühlmittel geschaffen werden. Besonders vorteilhaft sind die Distanznoppen zwischen der Öffnung der Ablaufebene beziehungsweise zwischen den Öffnungen der Ablaufkanäle und dem Vertiefungskanal angeordnet.

In einer weiteren bevorzugten Ausführungsform ist der Grundkörper aus mehreren Elementschichten gebildet, was eine grosse Variation in der Ausgestaltung des Grundkörpers und einfache Fertigung desselben ermöglicht. Zudem lassen sich beispielsweise aufgrund von Temperaturdifferenzen auftretende Spannungen innerhalb dieser Elementschichten ausgleichen, ohne dass Verformungen des Kühlelementes auftreten können. Diese Verformungen könnten zu Verwerfungen insbesondere im Bereich der mit der Solarzelle in Anlage bringbare Anlagefläche führen, so dass sich das an der Solarzelle festgelegte Kühlelement bereichsweise lösen könnte. In den losgelösten Bereichen ist eine optimale Kühlung der Solarzelle nicht mehr geleistet. Zudem würden in den losgelösten Bereichen Undichtigkeiten auftreten, welche das gesamte Strömungsverhalten des Kühlmittels im Kühlelement stören und gegebenenfalls eine Kühlfunktion des Kühlelementes verhindern. Bei einem mehrschichtigen Grundkörper werden die vorgenannten Gefahren verhindert.

Die einzelnen Elementschichten sind vorteilhaft Stanz-/Biegeteile aus Aluminium- oder Stahlblech, welche einfach in die gewünschte Form bringbar und mit entsprechenden Ausnehmungen versehbar sind.

Da die Elementschichten üblicherweise separat gefertigt werden, sind die Anforderungen an die Minimalabmessungen der einzelnen Elementschichten, insbesondere in Bezug auf deren Höhenabmessungen, kleiner als bei einem einteilig gefertigten Grundkörper. Denn die minimale Höhe eines einteiligen Grundkörpers ist im Wesentlichen durch die Minimalabmessungen der Formelemente zur Ausbildung der Öffnungen und Kanäle innerhalb des einteilig gefertigten Grundkörpers bestimmt.

Ein mehrschichtiger Grundkörper kann mit einer gesamten Höhenabmessung im Bereich von 8 mm bis 20 mm, vorteilhaft von 10 mm bis 14 mm gefertigt werden. Dadurch sind Solarmodulelemente und Anordnungen aus mehreren, in einer Ebene angeordneten Kühlelementen ausführbar, welche nur eine geringe Bauhöhe aufweisen und sich vorteilhaft in einen Baukörper integrieren oder an einem Baukörper anordnen lassen. Die archetektonische Freiheit bei der Gestaltung eines Bauwerks mit Solarzellen wird wesentlich geringer als bei heutigen Lösungen eingeschränkt, wobei die Vorteile einer gekühlten Solarzelle erhalten bleiben. Die verhältnismässig geringe Dicke eines Solarmodulelementes aufgrund diesem erfindungsgemässen Kühlelement ermöglicht vorteilhafte Anordnungen auch an Wänden eines Bauwerks.

Vorteilhaft sind zumindest zwei Elementschichten über Verbindungsmittel miteinander verbunden, so dass der mehrschichtige Grundkörper einfach handhabbar ist. Besonders vorteilhaft sind alle Elementschichten eines Grundkörpers über Verbindungsmittel miteinander verbunden, so dass der mehrschichtige Grundkörper ein Bauteil bildet und somit noch einfacher handhabbar ist.

Zumindest eines der Verbindungsmittel ist vorteilhaft ein Klebstoff, der eine einfache Fertigung der Verbindung zwischen den entsprechenden Elementschichten des Grundkörpers ermöglicht. Besonders vorteilhaft kommt für alle Verbindungsmittel ein Kleber zur Anwendung. Besonders geeignet haben sich Kleber erwiesen, wie sie im Automobilbereich zur Festlegung von Autoscheiben zur Anwendung kommen. Derartige Kleber weisen eine hohe Temperaturbeständigkeit und Elastizität über eine lange Gebrauchsdauer auf.

Vorzugsweise sind zumindest zwischen zwei Elementschichten des mehrschichtigen Grundkörpers Ausgleichsräume vorgesehen, damit sich gegebenenfalls auftretende Spannungen einfach innerhalb des Grundkörpers abbauen können. Die Ausgleichsräume werden beispielsweise durch Bereiche zwischen zumindest zwei Elementschichten gebildet, in denen keine Verbindungsmittel zum Verbinden dieser Elementschichten vorgesehen sind.

Bevorzugt sind zumindest ein Teil der Kühlkammern becherförmig ausgebildet, womit insbesondere der Aufnahmeraum konstruktiv einfach ausgebildet werden kann. Durch eine becherförmige Ausgestaltung lässt sich eine vorteilhafte Strömungsführung innerhalb des Kühlkörpers ermöglichen. Beispielsweise weist die entsprechende Kühlkammer abgesetzte Abschnitte auf, in denen jeweils die Zulauföffnung beziehungsweise die Ablauföffnung entsprechend vorgesehen sind.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung beschrieben sind. Dabei können die in den Ansprüchen und in der Beschreibung erwähnten Merkmale jeweils einzeln für sich oder in beliebiger Kombination erfindungswesentlich sein.

Die Bezugszeichenliste ist Bestandteil der Offenbarung. Die Figuren werden zusammenhängend und übergreifend beschrieben. Gleiche Bezugszeichen bedeuten gleiche bzw. ähnliche Bauteile.

Es zeigen dabei:
- Fig. 1: eine Solarzelle mit einem erfindungsgemässen Kühlelement in schematischer Schnittdarstellung,
- Fig. 2: eine schematische Darstellung des Kühlmittelstromes in einem erfindungsgemässen Kühlelement,
- Fig. 3: einen Schnitt durch ein zweites erfindungsgemässes Ausführungsbeispiel eines Kühlelementes,
- Fig. 4: einen Schnitt durch das Kühlelement entlang der Ebene IV-IV in Fig. 3,
- Fig. 5: einen weiteren Schnitt durch das Kühlelement entlang der Ebene V-V in Fig. 3,
- Fig. 6: einen weiteren Schnitt durch das Kühlelement entlang der Ebene VI-VI in Fig. 3,
- Fig. 7: eine Anordnung aus vier Kühlelementen,
- Fig. 8: einen Detailschnitt entlang der Linie VIII-VIII in Fig. 7,
- Fig. 9: einen Detailschnitt entlang der Linie IX-IX in Fig. 7,
- Fig. 10: einen Detailschnitt entlang der Linie VIII-VIII in Fig. 7,
- Fig. 11: ein drittes erfindungsgemässes Ausführungsbeispiel eines Kühlelementes in einer perspektivischen Darstellung,
- Fig. 12: eine Detailansicht mit einem schematisch dargestellten Strömungsverlauf in einem Kühlelement gemäss Fig. 11,
- Fig. 13: einen Ausschnitt auf eine (Wellen-)Elementelemtschicht,
- Fig. 14: einen Ausschnitt auf eine erste Zwischenelementschicht,
- Fig. 15: einen Ausschnitt auf eine zweite Zwischenelementschicht,
- Fig. 16: ein becherförmiges Kühlkammerelement in einer Aufsicht, und
- Fig. 17: das becherförmige Kühlkammerelement gemäss Figur 16 in einer Seitenansicht.

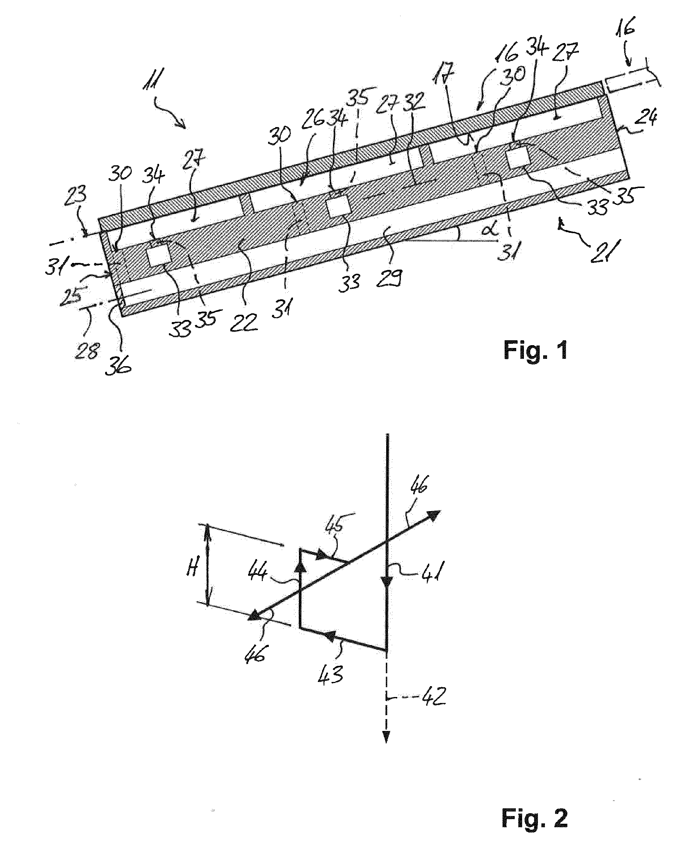

Die Figur 1 zeigt ein Solarmodulelement 11, das mehrere, in Reihe geschaltete und in einer Ebene angeordnete Solarzellen 16 umfasst.

An der Rückseite 17 der Solarzelle 16 ist ein erfindungsgemässes Kühlelement 21 angeordnet, beispielsweise angeklebt. Das Kühlelement 21 weist einen im Wesentlichen quadratischen Grundkörper 22 auf, der eine mit der Rückseite 17 der Solarzelle 16 in Anlage bringbare Anlagefläche 23 sowie Seitenwände 24, 25 aufweist. Die Solarzelle 16 und das Kühlelement 21 sind in diesem Beispiel zur Horizontalen in einem Winkel α geneigt angeordnet.

Das Kühlelement 21 ist aus einem wärmebeständigen jedoch aus einem im Wesentlichen nicht-wärmeleitfähigen Material gefertigt. Besonders vorteilhaft ist das Kühlelement 21 bei der gezeigten einteiligen Ausführungsform aus einem Styrodur oder vergleichbarem Material gefertigt, welches neben den vorgenannten Eigenschaften einfach an der Rückseite einer Solarzelle 16 festlegbar ist, beispielsweise mittels eines Klebers. Des Weiteren weist insbesondere Styrodur eine vorteilhafte Dichtigkeit zum Führen des Kühlmittels in dem Kühlelement 21 auf. Das Styrodur oder das vergleichbare Material wird beispielsweise in einer entsprechend ausgebildeten Form aufgeschäumt, so dass in einem Arbeitsgang das Kühlelement 21 ausgeformt wird und dieses somit einfach herstellbar ist.

Weiter ist an dem Kühlelement 21 ein zur Anlagefläche 23 offener Aufnahmeraum 26 für ein Kühlmittel zur Kühlung der Solarzelle 16 an deren Rückseite 17 ausgebildet, wobei der Aufnahmeraum 26 mehrere, nebeneinander angeordnete Kühlkammern 27 aufweist.

Der Zulauf für das Kühlmittel erfolgt in einer Zulaufebene 28, die parallel zur Anlagefläche 23 verläuft. In der Zulaufebene 28 sind mehrere, voneinander beabstandete Zulaufkanäle 29 mit einer Längserstreckung vorgesehen, wobei in dieser Darstellung nur der in Längserstreckung durchschnittene Zulaufkanal 29 sichtbar ist. Die anderen Zulaufkanäle 29 liegen, bezogen auf die Blattebene vor beziehungsweise hinter dem sichtbaren Zulaufkanal 29.

Der Ablauf für das Kühlmittel erfolgt in einer Ablaufebene 32, die ebenfalls parallel zur Anlagefläche 23 verläuft und zwischen der Anlagefläche 23 und der Zulaufebene 28 angeordnet ist. In der Ablaufebene 32 sind mehrere, hier z. B. drei, voneinander beabstandete Ablaufkanäle 33 mit einer Längserstreckung vorgesehen, wobei in dieser Darstellung die Ablaufkanäle 33 im Querschnitt quer zu deren Längserstreckung gezeigt sind. Die Längserstreckung der Ablaufkanäle 33 verläuft quer beziehungsweise senkrecht zur Längserstreckung der Zulaufkanäle 29.

Jede der Kühlkammern 27 weist jeweils eine Zulauföffnung 30 sowie eine Ablauföffnung 34 auf. Die Zulauföffnung 30 ist beabstandet zu der Ablauföffnung 34 angeordnet. In der dargestellten, geneigten Anordnung des Kühlelementes 21 ist die Zulauföffnung 30 in Bezug auf die Falllinie des Kühlelementes 21 unterhalb der Ablauföffnung 34 angeordnet.

Bei jeder Kühlkammer 27 ist ein erster Verbindungskanal 31 vorgesehen, welcher den entsprechenden Zulaufkanal 29 mit der Zulauföffnung 30 dieser Kühlkammer 27 verbindet. Weiter ist bei jeder Kühlkammer 27 ein zweiter Verbindungskanal 35 vorgesehen, welcher die Ablauföffnung 34 dieser Kühlkammer 27 mit dem entsprechenden Ablaufkanal 33 verbindet.

Der Querschnitt quer zur Längserstreckung eines Zulaufkanals 29 ist 5-mal bis 15-mal, vorteilhaft 8-mal bis 12-mal grösser als der Querschnitt quer zur Längserstreckung eines Ablaufkanals 33 ausgebildet.

Die Zulaufkanäle 29 sind in diesem Beispiel zu der Seitenwand 24 hin offen, so dass ein dem Kühlelement 21 zugeführtes Kühlmittel in die Kühlkammern 27 strömen kann. Die Ablaufkanäle 33 sind zu beiden, einander gegenüberliegenden Seitenwänden, welche in dieser Darstellung nicht ersichtlich sind, offen.

Anhand der Figur 2 lässt sich der Verlauf des Kühlmittels im Bereich einer Kühlkammer 27 erkennen. Das Kühlmittel, z. B. denaturiertes Wasser, strömt in Richtung des Pfeils 41 durch den entsprechenden Zulaufkanal 29. Durch den ersten Verbindungskanal 31 strömt das Kühlmittel in die entsprechende Kühlkammer 27 (Pfeil 43). Durch die Kühlkammer 27 strömt das Kühlmittel in Richtung des Pfeils 44 und verlässt diese durch den zweiten Verbindungskanal 35 in den entsprechenden Ablaufkanal 33, in welchem das Kühlmittel quer zur Richtung des Pfeils 41 zu beiden Seiten hin wegströmen kann (Pfeile 46). Ist am Ende des Zulaufkanals 29 kein diesen verschliessender Abschnitt 36, wie in der Figur 1 gezeigt, vorgesehen, strömt ein Teil des Kühlmittels in Richtung des gestrichelt dargestellten Pfeils 42 weiter.

Das Kühlmittel ist nur in dem von der Kühlkammer 27 definierten Bereich mit der Rückseite 17 der Solarzelle 16 in Kontakt. Durch die Vielzahl von Kühlkammern 27 und der Ausgestaltung des Kühlelementes weist das Kühlmittel in allen Bereichen der Solarzelle 16 im Wesentlichen das gleiche Temperaturniveau auf. Damit steht überall an der Solarzelle die im Wesentlichen gleiche Temperaturdifferenz zwischen dem Kühlmittel und der Solarzelle 16 zur Verfügung, womit eine gleichmässige und optimale Kühlung der gesamten Solarzelle 16 sichergestellt ist. Des Weiteren weisen alle Kühlkammern 27 vorteilhaft die gleiche Höhendifferenz H zwischen der Zulauföffnung 30 und der Ablauföffnung 34 auf, womit über das gesamte Kühlelement 21 die gleiche Druckdifferenz in diesem Bereich des Kühlelementes 21 gegeben ist.

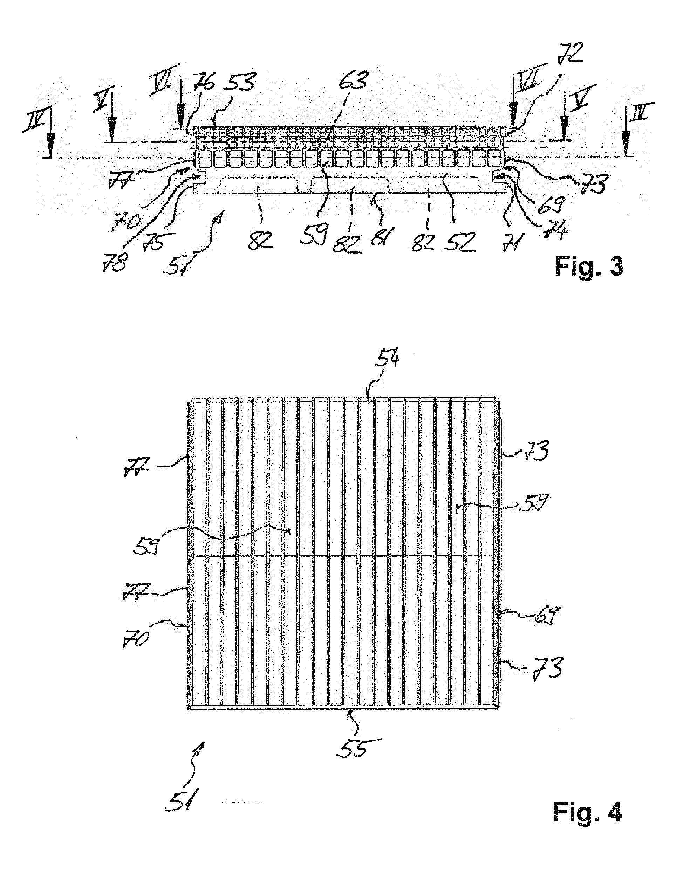

In den Figuren 3 bis 6 ist eine weitere Ausführungsform eines Kühlelementes 51 dargestellt. Die prinzipielle Ausgestaltung des Kühlelementes 51 ist weitgehend mit der Ausgestaltung des zuvor beschriebenen Kühlelementes 21 vergleichbar.

Der Grundkörper 52 ist in diesem Beispiel aus Styrodur gefertigt, beispielsweise geschäumt. An der der Anlagefläche 53 abgewandten Seite 81 sind mehrere zueinander beabstandete Ausnehmungen 82 zur Reduktion des erforderlichen Materialbedarfs bei gleichzeitiger Gewährleistung einer ausreichenden Stabilität vorgesehen.

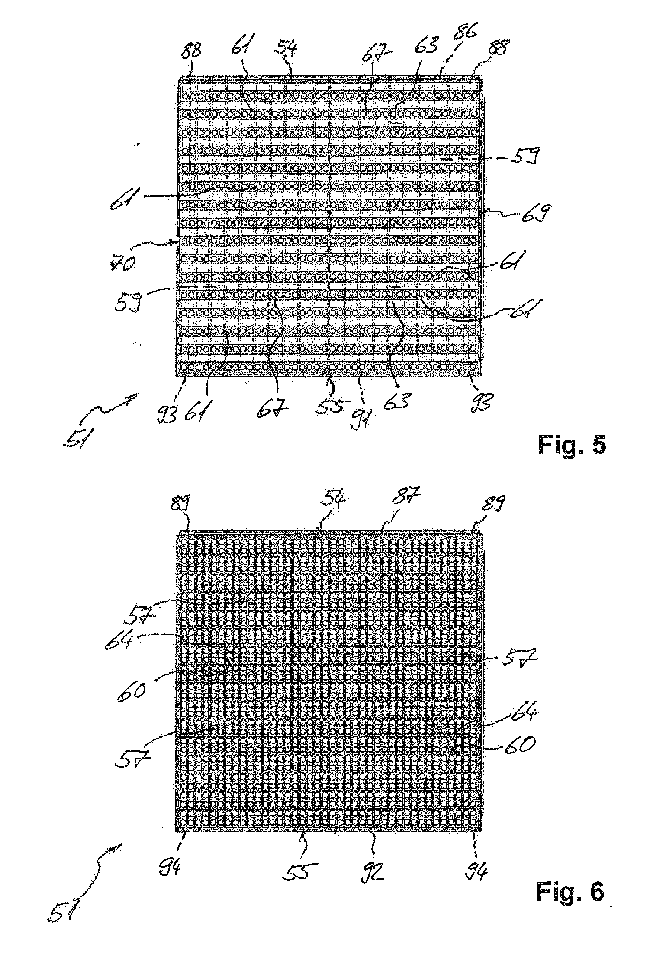

Aus der Figur 4 ist ersichtlich, dass die Zulaufkanäle 59 zu den beiden, einander gegenüberliegenden Seitenwänden 54 und 55 hin offen sind. Die Ablaufkanäle 63 sind hingegen zu den Seitenwänden 69 und 70 hin offen und verlaufen somit quer zu der Längserstreckung der Zulaufkanäle 59 (Figur 5).

Zwischen den Ablaufkanälen 63 sind Stege 67 ausgebildet. In den Stegen 67 sind die ersten Verbindungskanäle 61 angeordnet, welche die Zulaufkanäle 59 mit den Kühlkammern 57 beziehungsweise mit deren Zulauföffnung 60 verbinden. Die Ablauföffnungen 64 sind jeweils mit einem der Ablaufkanäle 63 verbunden.

Wie die Darstellung gemäss Figur 6 zeigt, weist das Kühlelement 51 eine Vielzahl von Kühlkammern 57 auf.

Wie insbesondere aus der Figur 3 ersichtlich, weist die Seitenwand 69 einen ersten Kamm 71 und einen dazu beabstandeten zweiten Kamm 72 auf, welche jeweils von der Seitenwand 69 abragen. In diesem Beispiel erstrecken sich die Kämme 71 und 72 im Wesentlichen über die gesamte Länge der Seitenwand 69 und bilden einen ersten Teil einer Verbindungseinrichtung zum Verbinden zweier Kühlelemente 51 aus. Weiter sind an der Seitenwand 69 mehrere, zueinander beabstandete und in gleicher Höhe in Bezug auf die Anlagefläche 53 angeordnete Distanznocken 73 vorgesehen. In Bezug auf die Anlagefläche 53 unterhalb dieser Distanznocken 73 beziehungsweise zwischen diesen und dem Kamm 71 ist ein Vertiefungskanal 74 ausgebildet, der sich quer zur Längserstreckung der Ablaufkanäle 63 beziehungsweise parallel zur Längserstreckung der Zulaufkanäle 59 über die gesamte Länge der Seitenwand 69 erstreckt.

Die Seitenwand 70 weist eine erste Nut 75 und eine dazu beabstandete zweite Nut 76 auf, welche in diesem Beispiel sich im Wesentlichen über die gesamte Länge der Seitenwand 70 erstrecken und einen zweiten Teil der Verbindungseinrichtung zum Verbinden zweier Kühlelemente 51 ausbilden. Die Nuten 75 und 76 sind komplementär zu den Kämmen 71 und 72 ausgebildet. Weiter sind an der Seitenwand 70 mehrere, zueinander beabstandete und in gleicher Höhe in Bezug auf die Anlagefläche 53 angeordnete Distanznocken 77 vorgesehen. In Bezug auf die Anlagefläche 53 unterhalb dieser Distanznocken 77 beziehungsweise zwischen diesen und der Nut 75 ist ein Vertiefungskanal 78 ausgebildet, der sich quer zur Längserstreckung der Ablaufkanäle 63 beziehungsweise parallel zur Längserstreckung der Zulaufkanäle 59 über die gesamte Länge der Seitenwand 70 erstreckt.

Auch die Seitenwand 54 weist einen ersten Kamm 86 und einen dazu beabstandeten zweiten Kamm 87 auf (Figuren 5 und 6), welche jeweils von der Seitenwand 54 abragen und in diesem Beispiel sich nicht über die gesamte Länge der Seitenwand 69 erstrecken. In Verlängerung des ersten Kamms 86, zwischen dessen Enden und dem Ende der Seitenwand 54 ist jeweils eine Justiernocke 88 vorgesehen. In Verlängerung des zweiten Kamms 87, zwischen dessen Enden und dem Ende der Seitenwand 54 ist ebenfalls jeweils eine Justiernocke 89 vorgesehen. Die Kämme 86, 87 und die Justiernocken 88, 89 bilden zusammen einen ersten Teil einer weiteren Verbindungseinrichtung zum Verbinden zweier Kühlelemente 51 aus.

Die Seitenwand 55 weist eine erste Nut 91 und eine dazu beabstandete zweite Nut 92 auf (Figuren 5 und 6), welche in diesem Beispiel sich nicht über die gesamte Länge der Seitenwand 55 erstrecken. In Verlängerung der ersten Nut 91, zwischen dessen Enden und dem Ende der Seitenwand 55 ist jeweils eine Justierausnehmung 93 vorgesehen. In Verlängerung der zweiten Nut 92, zwischen dessen Enden und dem Ende der Seitenwand 55 ist jeweils eine Justierausnehmung 94 vorgesehen. Die Nuten 91, 92 und die Justierausnehmungen 93, 94 bilden zusammen einen zweiten Teil der weiteren Verbindungseinrichtung zum Verbinden zweier Kühlelemente 51 aus. Die Nuten 91 und 92 sind komplementär zu den Kämmen 86 und 87 ausgebildet. Die Justierausnehmungen 93 und 94 sind komplementär zu den Justiernocken 88 und 89 ausgebildet.

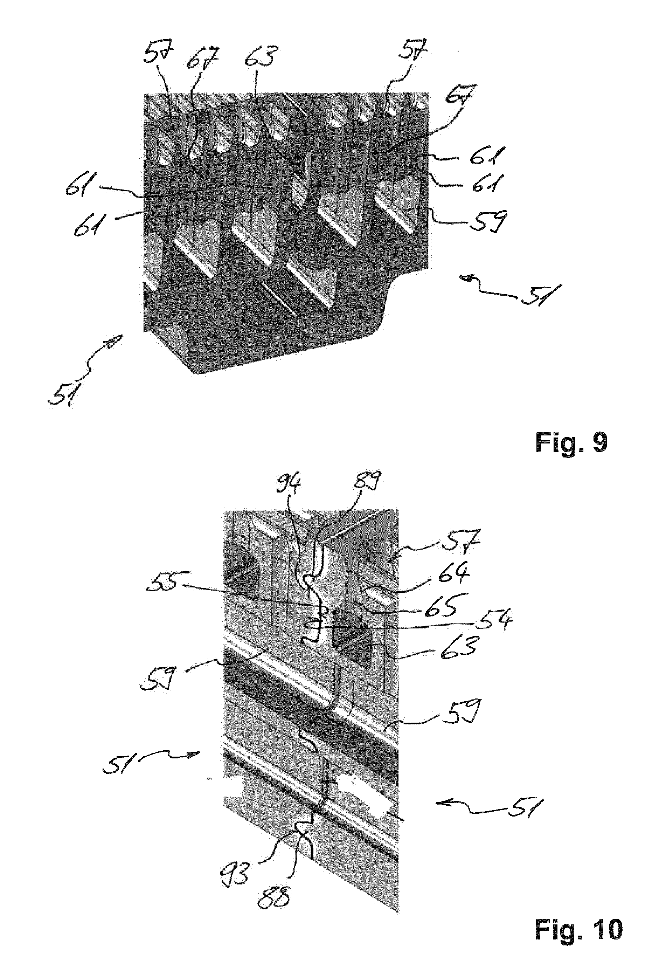

Die Wandungen der Zulaufkanäle 59 überragen in diesem Beispiel die Seitenwand 54. Die Wandungen der Zulaufkanäle 59 sind in diesem Beispiel gegenüber der von der Seitenwand 55 aufgespannten Ebene zurückversetzt. Beim Zusammenführen zweier Kühlelemente 51 dringen die die Seitenwand 54 überragenden Wandungsabschnitte der Zulaufkanäle 59 in die durch die zurückversetzten Wandungsabschnitte der Zulaufkanäle 59 geschaffene Aufnahme ein (Figur 10).

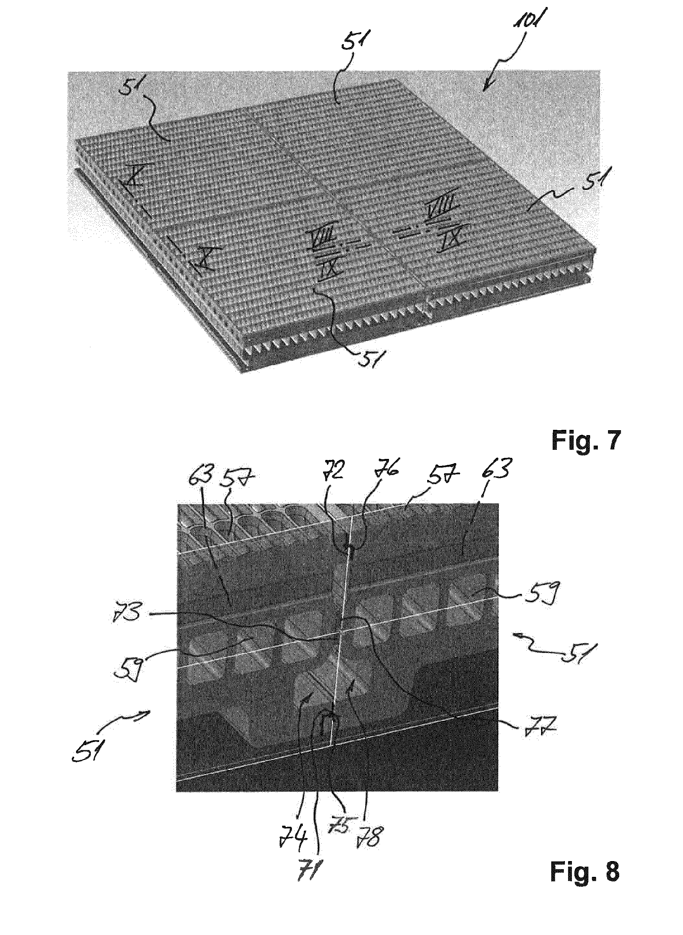

Figur 7 zeigt vier miteinander verbundene Kühlelemente 51, die eine Anordnung 101 ausbilden. Die Figuren 8 bis 10 zeigen die Details der Verbindungseinrichtungen im zusammengeführten Zustand der Kühlelemente 51.

Wie in der Figur 8 ersichtlich, bildet sich im zusammengeführten Zustand der Kühlelemente 51 aufgrund der Vertiefungskanäle 74 und 78 ein Ablauf zum Abführen des Kühlmittels aus. Weiter ist hier erkennbar, dass die Distanznocken 73 und 77 miteinander in Anlage kommen, wobei zwischen diesen Durchgänge für den Durchtritt von aus den Ablaufkanälen 63 austretendem Kühlmittel in den Ablauf vorhanden sind.

Die in den Stegen 67 vorgesehenen ersten Verbindungskanäle 61, welche die Zulaufkanäle 59 mit den entsprechenden Kühlkammern 57 verbinden, sind im Detail nochmals in der Figur 9 dargestellt.

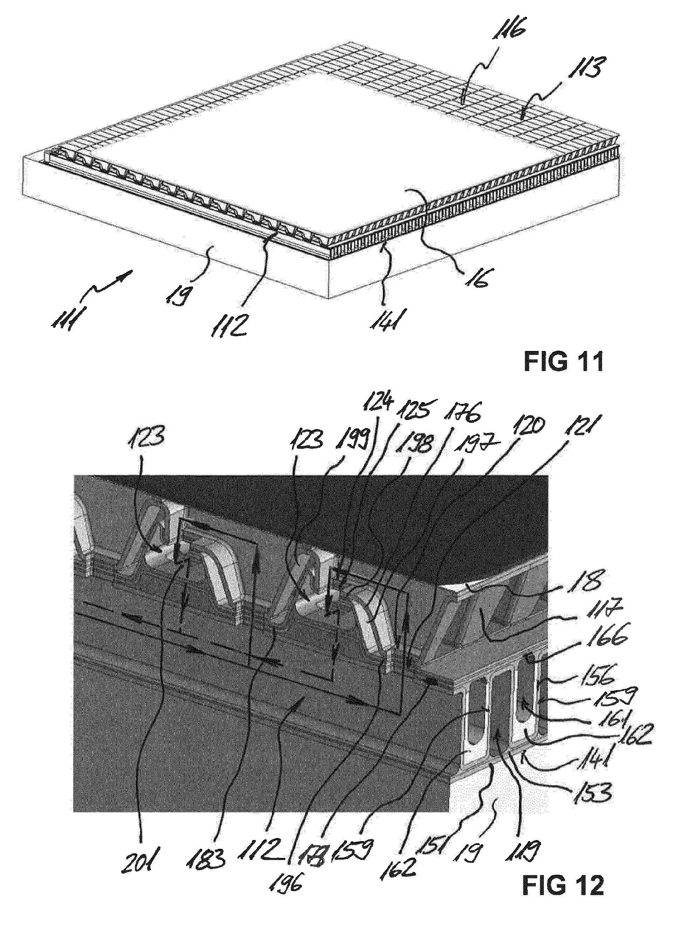

Das in der Figur 11 sowie im Detail in den Figuren 12 bis 17 gezeigte Ausführungsbeispiel eines Kühlelementes 111 zur Anordnung an der Rückseite der Solarzelle 16 weist einen mehrschichtigen Grundkörper 112 auf. Zwischen der Solarzelle 16 und der Anlagefläche 113 des Grundkörpers 112 ist vorteilhaft eine Schutzfolie, besonders vorteilhaft eine Tedlarfolie 18 vorgesehen. An der unteren Seite 141 des Grundkörpers 112 ist eine thermische Isolation 19, z. B. aus Styrodur, Steinwolle oder dergleichen, angeordnet.

Der Grundkörper 112 ist aus mehreren Elementschichten gebildet. Ausgehend von der unteren Seite 141 des Grundkörpers 112 ist eine Basiselementschicht 151 vorgesehen. Die Basiselementschicht 151 ist z. B. aus Blech gefertigt und weist eine flächige Ausgestaltung ohne Öffnungen beziehungsweise Ausnehmungen auf.

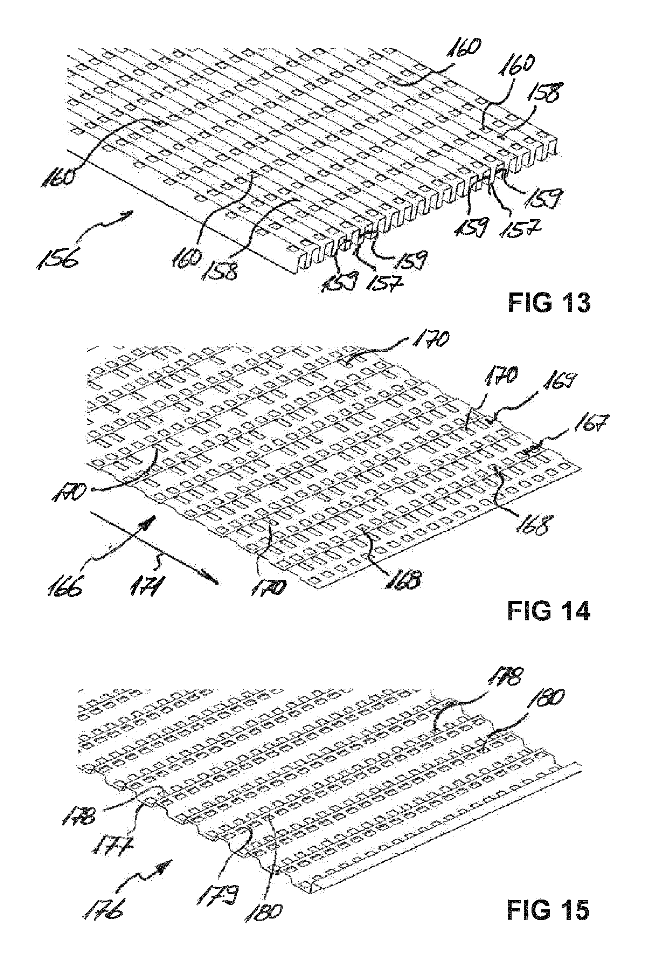

Auf der Basiselementschicht 151 ist eine Wellenelementschicht 156 vorgesehen (siehe auch Figur 13), welche mehrere mit der Basiselementschicht 151 in Anlage bringbare erste Anlageabschnitte 157 und in Bezug auf die Höhe der Wellenelementschicht 156 dazu beabstandete, mit einer nachfolgenden ersten Zwischenelementschicht 166 in Anlage bringbare zweite Anlageabschnitte 158 aufweist. Die ersten Anlageabschnitte 157 und die zweiten Anlageabschnitte 158 sind jeweils über parallel zueinander verlaufende Seitenwandabschnitte 159 miteinander verbunden und in Querrichtung alternierend angeordnet. Die Bereiche der Wellenelementschicht 156, welche in Richtung der Basiselementschicht 151 offen sind, bilden im zusammengeführten Zustand des Grundkörpers 112 die Zulaufkanäle 119 des Kühlelementes 111 aus. Die Bereiche der Wellenelementschicht 156, welche in der von der Basiselementschicht 151 abgewandten Richtung offen sind, bilden im zusammengeführten Zustand des Grundkörpers 112 Rücklaufkanäle 161 aus.

In den Rücklaufkanälen 161 sind vorteilhaft Einlageelemente 162 vorgesehen, welche entsprechend den Strömungsverhältnissen innerhalb des Kühlelementes 111 ausgebildet sind und unerwünschte Ablagerungen im Bereich der entsprechenden Abbiegungen der Wellenelementschicht 156 verhindern.

In den zweiten Anlageabschnitten 158, welche in Bezug auf die Darstellungen oben zu liegen kommen, sind jeweils in regelmässigen Abständen Zulaufausnehmungen 160 vorgesehen, welche den Durchtritt des Kühlmediums aus den Zulaufkanälen 119 in die nachfolgend noch beschriebenen Kühlkammerelementen 117 ermöglichen.

Die Wellenelementschicht 156 ist über eine erste Klebeschicht 153 als Verbindungsmittel mit der Basiselementschicht 151 verbunden. Die erste Klebeschicht 153 ist im entsprechenden Randbereich der Zulaufkanäle 119 teilweise nach oben gezogen und dort als Hohlkehle ausgebildet. Dies gewährleistet in den Zulaufkanälen 119 entsprechend vorteilhafte Strömungsverhältnisse innerhalb des Kühlelementes 111 und verhindert unerwünschte Ablagerungen im Bereich der entsprechenden Abbiegungen der Wellenelementschicht 156.

Die Wellenelementschicht 156 ist hier ein aus Aluminiumblech gefertigtes Stanz-/Biegeteil.

Auf die Wellenelementschicht 156 folgt eine erste Zwischenelementschicht 166 (siehe auch Figur 14), welche ebenfalls aus einem Aluminiumblech gefertigt und ein Stanz-/Biegeteil ist. Die erste Zwischenelementschicht 166 weist in eine Richtung eine wellenförmige Ausgestaltung aus, nämlich in die Richtung, welche im zusammengebauten Zustand des Grundkörpers 112 der Längserstreckung der Zulaufkanäle 119 entspricht. In den ersten Abschnitten 167 der ersten Zwischenelementschicht 166, welche der Wellenelementschicht 156 zugewandt sind, sind Zulaufausnehmungen 168 für den Durchtritt des Kühlmediums aus den Zulaufkanälen 119 in die Kühlkammerelemente 117 vorgesehen. In den zweiten Abschnitten 169 der ersten Zwischenelementschicht 166, welche der Wellenelementschicht 156 abgewandt sind, sind Ablaufausnehmungen 170 für den Austritt des Kühlmediums aus den Kühlkammern 117 in die Rücklaufkanäle 161 vorgesehen. Bezogen auf die Pfeilrichtung des Pfeils 171 nimmt in deren Richtung die Anzahl der Ablaufausnehmungen 170 vorteilhaft von einem zweiten Abschnitt 169 zum nächsten zweiten Abschnitt 169 jeweils zu. Mit anderen Worten weisen die in Pfeilrichtung vorderen zweiten Abschnitte 169 eine grössere Anzahl von Ablaufausnehmungen 170 als die dahinter liegenden zweiten Abschnitte 169 auf. Durch diese Massnahme lässt sich einfach der Einfluss der Schwerkraft auf das Kühlmittel kompensieren, so dass auch bei einem gegenüber einer Horizontalen in einem Winkel angeordneten Kühlelement 111 eine Austausch des Kühlmittels in allen Kühlkammerelementen 117 des Kühlelementes 111 gewährleistet ist.

Anstelle der Variation der Anzahl kann auch die Grösse des entsprechenden Öffnungsquerschnitts der Ablaufausnehmungen 170 variiert werden. In dieser Variante würden die Ablaufausnehmungen 170 in den in Pfeilrichtung vorderen zweiten Abschnitten 169 einen grösseren Öffnungsquerschnitt als die Ablaufausnehmungen 170 in den dahinter liegenden zweiten Abschnitten 169 aufweisen.

Die Wellenelementschicht 156 und die erste Zwischenelementschicht 166 sind über eine zweite Klebeschicht 173 als Verbindungsmittel miteinander verbunden. Die zweite Klebeschicht 173 füllt in diesem Ausführungsbeispiel alle Zwischenräume zwischen der Wellenelementschicht 156 und der ersten Zwischenelementschicht 166 ausser im Bereich der Ausnehmungen aus. Im Bereich der Rücklaufkanäle 161 ist die zweite Klebeschicht 173 jeweils bereichsweise bis zu den freien Enden der Einlageelemente 162 gezogen und jeweils in den Übergangsbereichen als Hohlkehle ausgeformt.

Auf die erste Zwischenelementschicht 166 folgt eine zweite Zwischenelementschicht 176 (siehe auch Figur 15), welche ebenfalls aus einem Aluminiumblech gefertigt und ein Stanz-/Biegeteil ist. Die zweite Zwischenelementschicht 176 weist in eine Richtung ebenfalls eine wellenförmige Ausgestaltung aus, nämlich in die Richtung, welche im zusammengebauten Zustand des Grundkörpers 112 der Längserstreckung der Zulaufkanäle 119 entspricht. Im Gegensatz zu der ersten Zwischenelementschicht 166 ist die wellenförmige Ausgestaltung jedoch aus mehreren aneinandergereihten trapezförmigen Abschnitten gebildet.

In den ersten Abschnitten 177 der zweiten Zwischenelementschicht 176, welche der ersten Zwischenelementschicht 166 zugewandt sind, sind Zulaufausnehmungen 178 für den Durchtritt des Kühlmediums aus den Zulaufkanälen 119 in die Kühlkammern 117 vorgesehen. In den zweiten Abschnitten 179 der zweiten Zwischenelementschicht 176, welche der ersten Zwischenelementschicht 166 abgewandt sind, sind Ablaufausnehmungen 180 für den Austritt des Kühlmediums aus den Kühlkammern 117 in die nachfolgend noch beschriebenen Ablaufkanäle 123 vorgesehen, welche den Rücklaufkanälen 161 vorgeschaltet sind.

Die erste Zwischenelementschicht 166 und die zweite Zwischenelementschicht 176 sind über eine dritte Klebeschicht 183 als Verbindungsmittel miteinander verbunden. Die dritte Klebeschicht 183 füllt in diesem Ausführungsbeispiel jedoch nicht alle Zwischenräume zwischen der ersten Zwischenelementschicht 166 und der zweiten Zwischenelementschicht 176 aus. In den Darstellungen, insbesondere in der Darstellung gemäss Figur 12, ist erkennbar, dass jeweils der Bereich unterhalb des zweiten Abschnitts 179 der zweiten Zwischenelementschicht 176 einen Kanal begrenzt, nämlich den Ablaufkanal 123 für das Kühlmedium. Im Bereich der Ablaufkanäle 123 ist die dritte Klebeschicht 173 jeweils bereichsweise randseitig hochgezogen und jeweils in den Übergangsbereichen als Hohlkehle ausgeformt.

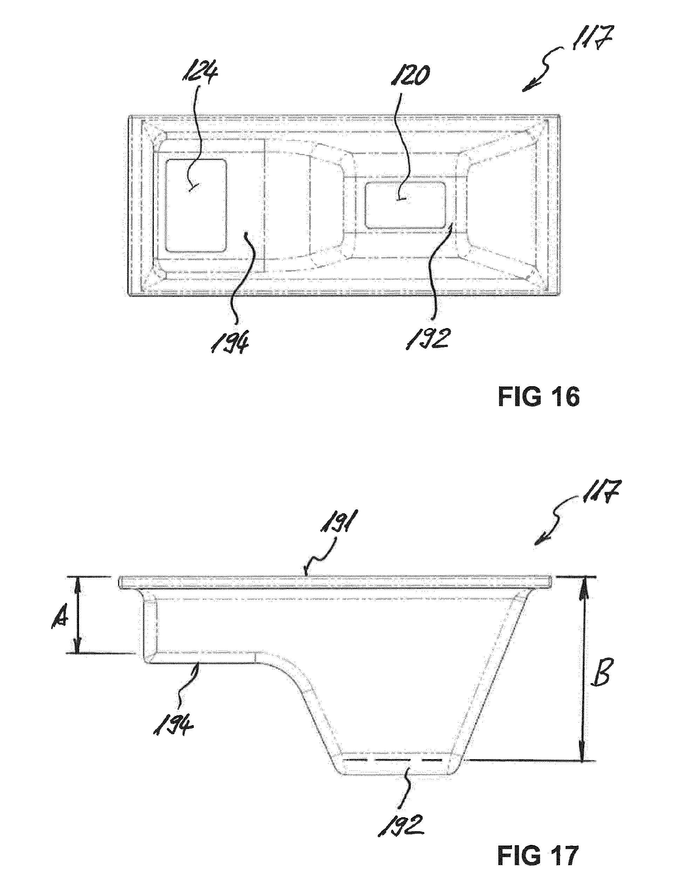

Als oberste Schicht folgen mehrere nebeneinander angeordnete becherförmige Kühlkammerelemente 117, welche jeweils, wie in den Figuren 16 und 17 dargestellt, ausgebildet sind. Das Kühlkammerelement 117 bildet somit einen Teil des zur Anlagefläche 113 des Kühlelementes 111 offenen Aufnahmeraums 116. Das Kühlkammerelement 117 weist einen ersten Bodenabschnitt 192 und einen zweiten Bodenabschnitt 194 auf, wobei der erste Bodenabschnitt 192 in Bezug auf den freien Rand 191 des becherförmigen Kühlkammerelementes 117 weiter von diesem als der zweite Bodenabschnitt 194 beabstandet ist. Der Abstand A des zweiten Bodenabschnitts 194 zum freien Rand 191 des becherförmigen Kühlkammerelementes 117 entspricht in diesem Ausführungsbeispiel dem 2.0-fachen bis 3.0-fachen, vorteilhaft dem 2.4-fachen bis 2.6-fachen, des Abstandes B des ersten Bodenabschnitts 192 zum freien Rand 191 des becherförmigen Kühlkammerelementes 117.

In dem ersten Bodenabschnitt 192 ist eine Zulauföffnung 120 und im zweiten Bodenabschnitt 194 ist eine Ablauföffnung 124 vorgesehen. Die Zulauföffnung 120 wie auch die Ablauföffnung 124 weisen im Grundriss jeweils einen rechteckigen Öffnungsquerschnitt auf, wobei deren Längserstreckung jeweils um 90° zueinander versetzt sind.

Wie insbesondere aus der Figur 12 ersichtlich, sind die nebeneinander gereihten becherförmigen Kühlkammerelemente 117 jeweils nur im Bereich des ersten Bodenabschnitts 192 über eine vierte Klebeschicht 196 als Verbindungsmittel und im Bereich des zweiten Bodenabschnitts 194 über eine fünfte Klebeschicht 198 als Verbindungsmittel mit der zweiten Zwischenschicht 176 verbunden. In den übrigen, der zweiten Zwischenschicht 176 zugewandten Bereichen der becherförmigen Kühlkammerelemente 117 sind die entsprechenden Wandabschnitt zu der zweiten Zwischenschicht 176 beabstandet, so dass in diesen Bereichen bei jedem becherförmigen Kühlkammerelement 117 Ausgleichsräume 197 bzw. 199 ausgebildet sind. Diese Ausgleichsräume 197 und 199 ermöglichen in den Abschnitten des Kühlelementes 111 mit den üblicherweise grössten Temperaturunterschieden des Kühlmediums einen vorteilhaften Ausgleich der gegebenenfalls und vor allem im Bereich der Anlagefläche 113 entstehenden Spannungen.

Auch bei dem Kühlelement 111 erfolgt der Zulauf des Kühlmittels in einer von den Zulaufkanälen 119 gebildeten Zulaufebene, welche parallel zu der Anlagefläche 113 angeordnet ist. Die Ablaufkanäle 123, deren Längserstreckung senkrecht zur Längserstreckung der Zulaufkanäle 119 verlaufen, bilden eine Ablaufebene für den Ablauf des Kühlmittels aus, die ebenfalls parallel zu der Anlagefläche 113 jedoch zwischen der von den Zulaufkanälen 119 gebildeten Zulaufebene und der Anlagefläche 113 angeordnet ist.

Die Zulaufausnehmungen 160 in der Wellenelementschicht 156, die Zulaufausnehmungen 168 in der ersten Zwischenelementschicht 166, die Zulaufausnehmungen 178 in der zweiten Zwischenelementschicht 176 und die in diesen Bereichen nicht vorgesehenen Klebeschichten 173, 183 sowie 196 bilden jeweils einen ersten Verbindungskanal 121 aus, welcher den entsprechenden Zulaufkanal 119 mit der Zulauföffnung 120 eines der becherförmigen Kühlkammerelemente 117 verbindet.

Die Ablaufausnehmungen 180 in der zweiten Zwischenelementschicht 176 und die in diesen Bereichen nicht vorgesehene fünfte Klebeschicht 198 bilden jeweils einen zweiten Verbindungskanal 125 aus, welcher den entsprechenden Ablaufkanal 123 mit der Ablauföffnung 124 eines der becherförmigen Kühlkammerelemente 117 verbindet.

Die Ablauföffnungen 170 in der ersten Zwischenelementschicht 166 sowie die in diesen Bereichen nicht vorgesehene zweite Klebeschicht 173 und dritte Klebeschicht 183 bilden jeweils einen dritten Verbindungskanal 201 aus, welcher den entsprechenden Ablaufkanal 123 mit dem Rücklaufkanal 161 verbindet.

Die Zulaufkanäle 119, die Rücklaufkanäle 161 sowie die Ablaufkanäle 123 sind jeweils zu den entsprechenden Seitenwänden des Grundkörpers 112 offen. Bei den Kühlelementen 111, welche im Bezug auf die Falllinie unten oder jeweils an den äusseren Seiten der Anordnung zu liegen kommen, werden die Zulaufkanäle 119, die Rücklaufkanäle 161 sowie die Ablaufkanäle 123 an den entsprechenden Enden verschlossen, damit der gewünschte Rückstau des Kühlmittels innerhalb der Anordnung sichergestellt ist.

In der Figur 12 ist schematisch der Strömungsverlauf dargestellt (siehe die mit Pfeilen ergänzten Linien). Das Kühlmittel strömt - hier von links - durch die Zulaufkanäle 119 in das Kühlelement 111 bis zu einem, hier nicht dargestellten, verschlossenen Ende. Aufgrund des daraus resultierenden Rückstaus des Kühlmittels strömt dieses, in Bezug auf die entsprechende Falllinie des Kühlelementes durch den untersten ersten Verbindungskanal 121 und die Zulauföffnung 120 in das becherförmige Kühlkammerelement 117 und kommt mit der Rückseite der Solarzelle 16 in Kontakt, wobei diese gekühlt wird. Durch die Ablauföffnung 124 und den zweiten Verbindungskanal 125 strömt das erwärmte Kühlmittel in den Ablaufkanal 123 und von diesem durch den dritten Verbindungskanal 201 in den Rücklaufkanal 161. In dem Rücklaufkanal 161 strömt das erwärmte Kühlmittel entgegengesetzt der Einströmrichtung desselben aus dem Kühlelement 111 heraus. Aufgrund des Rückstaus des Kühlmittels in den Zulaufkanälen 119 wird das Kühlelement 111 sukzessive gefüllt.

Die im erwärmten Kühlmittel gespeicherte Energie wird beispielsweise über einen Wärmetauscher, der ausserhalb der Solaranordnung vorgesehen sein kann, für eine weitere Nutzung abgeführt. Das somit wieder auf ein tieferes Temperaturniveau gebrachte Kühlmittel kann dann beispielsweise wieder zur Kühlung der Solarzellen 16 dem Kühlelement 111 zugeführt werden.

Vorteilhaft sind auch an einander gegenüberliegenden Seitenwänden des Grundkörpers 112 jeweils Teile einer Verbindungsvorrichtung vorgesehen, wobei vorteilhaft der eine Teil der Verbindungsvorrichtung an einer Seitenwand komplementär zu einem anderen Teil der Verbindungsvorrichtung an der gegenüberliegenden Seitenwand ausgebildet ist. Somit lassen sich mehrere Kühlelemente 111 einfach zu einer Anordnung verbinden und die entsprechenden Kanäle werden dabei für einen einwandfreien Durchfluss des Kühlmittels zueinander ausgerichtet. Die Verbindungsvorrichtung wird beispielsweise analog oder ähnlich wie die Verbindungsvorrichtungen bei dem Kühlelement 51 ausgebildet.

Ein erfindungsgemässes Solarmodulelement umfasst mehrere, in einer Ebene angeordnete Solarzellen 16 sowie mehrere, in einer Ebene angeordnete Kühlelemente 51 oder 111 zur Kühlung der Solarzellen 16.

Neben Solarzellen 16 mit einer flachen, ebenen Oberfläche, wie sie in den Figuren gezeigt sind, können Solarzellen auch eine gekrümmte, z. B. eine zylindrische oder teilzylindrische, Oberfläche aufweisen. Bei derartigen Solarzellen wird das Kühlelement der Kontur der Solarzelle folgend ausgeformt. Bei einer zylindrischen oder teilzylindrischen Solarzelle verläuft zumindest die Anlagefläche des Kühlelementes ebenfalls zylindrisch beziehungsweise teilzylindrisch.

### Bezugszeichenliste

- 11: Solarmodulelement

- 16: Solarzelle
- 17: Rückseite v. 16
- 18: Todlarfolie

- 21: Kühlelement
- 22: Grundkörper
- 23: Anlagefläche
- 24: Seitenwand
- 25: Seitenwand
- 26: Aufnahmeraum
- 27: Kühlkammer
- 28: Zulaufebene
- 29: Zulaufkanal
- 30: Zulauföffnung
- 31: 1. Verbindungskanal
- 32: Ablaufebene
- 33: Ablaufkanal
- 34: Ablauföffnung
- 35: 2. Verbindungskanal
- 36: verschliessender Abschnitt

- 41: Pfeil
- 42: Pfeil
- 43: Pfeil
- 44: Pfeil
- 45: Pfeil
- 46: Pfeil

- α: Winkel
- H: Höhendifferenz v. 30/34

- 86: Kamm
- 87: Kamm
- 88: Justiernocke
- 89: Justiernocke

- 51: Kühlelement
- 52: Grundkörper
- 53: Anlagefläche
- 54: Seitenwand
- 55: Seitenwand

- 57: Kühlkammer

- 59: Zulaufkanal
- 60: Zulauföffnung
- 61: 1. Verbindungskanal

- 63: Ablaufkanal
- 64: Ablauföffnung
- 65: 2. Verbindungskanal

- 67: Steg

- 69: Seitenwand
- 70: Seitenwand
- 71: Kamm
- 72: Kamm
- 73: Distanznocke
- 74: Vertiefungskanal
- 75: Nut
- 76: Nut
- 77: Distanznocke
- 78: Vertiefungskanal

- 81: (untere) Seite v. 52
- 82: Ausnehmung

- 156: Wollenelementschicht
- 157: 1. Anlageabschnitt
- 158: 2. Anlageabschnitt
- 159: Seitenwandabschnitt

- 91: Nut
- 92: Nut
- 93: Justierausnehmung
- 94: Justierausnehmung

- 101: Anordnung

- 111: Kühlelement
- 112: Grundkörper
- 113: Anlagefläche

- 116: Aufnahmeraum
- 117: Kühlkammerelement

- 119: Zulaufkanal
- 120: Zulauföffnung
- 121: 1. Verbindungskanal

- 123: Ablaufkanal
- 124: Ablauföffnung
- 125: 2. Verbindungskanal

- 141: (untere) Seite 112

- 151: Basiselement

- 153: 1. Klebschicht

- A: Abstand 191/194
- B: Abstand 191/192

- 160: Zulaufausnehmung
- 161: Rücklaufkanal
- 162: Einlageelement in 161

- 166: 1. Zwischenelementschicht
- 167: 1. Abschnitt
- 168: Zulaufausnehmung
- 169: 2. Abschnitt
- 170: Ablaufausnehmung
- 171: Pfeil

- 173: 2. Klebschicht

- 176: 2. Zwischenelementschicht
- 177: 1. Abschnitt
- 178: Zulaufausnehmung
- 179: 2. Abschnitt
- 180: Ablaufausnehmung

- 183: 3. Klebschicht

- 192: 1. Bodenabschnitt v. 117

- 194: 2. Bodenabschnitt v. 117

- 196: 4. Klebschicht
- 197: 1. Ausgleichsraum
- 198: 5. Klebschicht
- 199: 2. Ausgleichsraum

- 201: 3. Verbindungskanal

## Patentansprüche

1. Kühlelement zur Anordnung an zumindest einer Solarzelle (16) mit einem Grundkörper (22; 52; 112), der eine mit der Rückseite (17) der zumindest einen Solarzelle (16) in Anlage bringbare Anlagefläche (23; 53; 113), welche einen zur Anlagefläche (23; 53; 113) offenen Aufnahmeraum (26; 116) für ein Kühlmittel zur Kühlung der zumindest einen Solarzelle (16) aufweist, sowie zumindest einen Zulauf für das Kühlmittel und zumindest einen Ablauf für das Kühlmittel sowie Seitenwände (24, 25; 54, 55, 69, 70) aufweist, **dadurch gekennzeichnet, dass** der Aufnahmeraum (26; 116) mehrere, nebeneinander angeordnete Kühlkammern (27; 57; 117) aufweist, wobei jede der Kühlkammern (27; 57; 117) eine mit dem Zulauf verbundene Zulauföffnung (30; 60; 120) und eine mit dem Ablauf verbundene Ablauföffnung (34; 64; 124) aufweist.

2. Kühlelement nach Anspruch 1, **dadurch gekennzeichnet, dass** die Ablauföffnung (34; 64; 124) beabstandet zu der Zulauföffnung (30; 60; 120) angeordnet ist, wobei bei einer geneigten Anordnung des Kühlelementes (21; 51; 111) die Zulauföffnung (30; 60; 120) in Bezug auf die Falllinie des Kühlelementes (21; 51; 111) vorteilhaft unterhalb der Ablauföffnung (34; 64; 124) angeordnet ist.

3. Kühlelement nach Anspruch 1 oder 2, **dadurch gekennzeichnet, dass** der Zulauf des Kühlmittels in einer parallel zur Anlagefläche (23; 53; 113) angeordneten Zulaufebene (28) erfolgt.

4. Kühlelement nach einem der Ansprüche 1 bis 3, **dadurch gekennzeichnet, dass** der Ablauf des Kühlmittels in einer parallel zur Anlagefläche (23; 53; 113) angeordneten Ablaufebene (32) erfolgt.

5. Kühlelement nach Anspruch 4, **dadurch gekennzeichnet, dass** die Ablaufebene (32) zwischen der Anlagefläche (23; 53; 113) und der Zulaufebene (28) angeordnet ist.

6. Kühlelement nach einem der Ansprüche 3 bis 5, **dadurch gekennzeichnet, dass** zumindest zwei, voneinander beabstandete Zulaufkanäle (29; 59; 119) mit einer Längserstreckung in der Zulaufebene (28) und/oder zumindest zwei, voneinander beabstandete Ablaufkanäle (33; 63; 123) mit einer Längserstreckung in der Ablaufebene (32) vorgesehen sind, wobei vorteilhaft die Längserstreckung der Ablaufkanäle (33; 63; 123) quer zur Längserstreckung der Zulaufkanäle (29; 59; 119) verläuft.

7. Kühlelement nach Anspruch 6, **dadurch gekennzeichnet, dass** der Querschnitt quer zur Längserstreckung eines Zulaufkanals (29; 59; 119) grösser als der Querschnitt quer zur Längserstreckung eines Ablaufkanals (33; 63; 123) ausgebildet ist, wobei vorzugsweise der Querschnitt des Zulaufkanals (29; 59; 119) 5-mal bis 15-mal, besonders vorteilhaft 8-mal bis 12-mal, grösser als der Querschnitt des Ablaufkanals (33; 63; 123) ausgebildet ist.

8. Kühlelement nach einem der Ansprüche 3 bis 7, **dadurch gekennzeichnet, dass** die Zulaufebene (28) und/oder die Ablaufebene (32) zu zumindest einer der Seitenwände (24, 25; 54, 55, 69, 70), vorteilhaft zu beiden, einander gegenüberliegenden Seitenwänden (24, 25; 54, 55, 69, 70) offen sind.

9. Kühlelement nach einem der Ansprüche 1 bis 8, **dadurch gekennzeichnet, dass** an einander gegenüberliegenden Seitenwänden (54, 55, 69, 70) des Grundkörpers (52) jeweils ein Teil einer Verbindungsvorrichtung vorgesehen ist, wobei vorteilhaft der eine Teil der Verbindungsvorrichtung an einer Seitenwand (54, 69) komplementär zu einem anderen Teil der Verbindungsvorrichtung an der gegenüberliegenden Seitenwand (55, 70) ausgebildet ist.

10. Kühlelement nach Anspruch 8 oder 9, **dadurch gekennzeichnet, dass** an einer der Seitenwände (69, 70) ein Vertiefungskanalabschnitt (74, 78) vorgesehen ist, wobei der Vertiefungskanalabschnitt (74, 78) vorteilhaft an der Seitenwand (69, 70) mit der offenen Ablaufebene vorgesehen ist, und der Vertiefungskanalabschnitt (74, 78) weiter vorteilhaft beanstandet zu der Öffnung der Ablaufebene (32) und weiter vorteilhaft die Längserstreckung des Vertiefungskanalabschnitts (74, 78) quer zur Längserstreckung der Ablaufkanäle (63) in der Ablaufebene verläuft.

11. Kühlelement nach einem der Ansprüche 1 bis 10, **dadurch gekennzeichnet, dass** der Grundkörper (112) aus mehreren Elementschichten (151, 156, 166, 176, 117) gebildet ist, wobei vorteilhaft zumindest zwei Elementschichten (117, 151, 156, 166, 176) über Verbindungsmittel miteinander verbunden sind, wobei vorteilhaft zumindest eines der Verbindungsmittel ein Klebstoff ist.

12. Kühlelement nach Anspruch 11, **dadurch gekennzeichnet, dass** zumindest zwischen zwei Elementschichten (117, 176) des Grundkörpers (112) Ausgleichsräume (197, 199) vorgesehen sind.

13. Kühlelement nach Anspruch 11 oder 12, **dadurch gekennzeichnet, dass** zumindest ein Teil der Kühlkammern (117) becherförmig ausgebildet sind.

14. Anordnung aus mehreren, in einer Ebene angeordneten Kühlelementen (21; 51; 111) nach einem der Ansprüche 1 bis 13 zur Kühlung mehrerer, in einer Ebene angeordneter Solarzellen (16).

15. Solarmodulelement umfassend mehrere, in einer Ebene angeordnete Solarzellen (16) sowie mehrere, in einer Ebene angeordnete Kühlelemente (21; 51; 111) nach einem der Ansprüche 1 bis 13 zur Kühlung der Solarzellen (16).
